(19) Europäisches Patentamt
European Patent Office
Office européen des brevets

(11) **EP 2 264 740 B1**

(12) **EUROPEAN PATENT SPECIFICATION**

(45) Date of publication and mention
of the grant of the patent:
**02.04.2014 Bulletin 2014/14**

(21) Application number: **09401012.1**

(22) Date of filing: **18.06.2009**

(51) Int Cl.:
*H01L 49/02* (2006.01)    *H01L 21/8242* (2006.01)
*G11C 11/401* (2006.01)    *H01F 10/32* (2006.01)
*H01G 4/008* (2006.01)    *H01L 27/108* (2006.01)
*B82Y 25/00* (2011.01)    *G11C 11/16* (2006.01)
*H01G 4/33* (2006.01)    *H01L 27/22* (2006.01)

(54) **DRAM cell with magnetic capacitor**

DRAM-Zelle mit magnetischem Kondensator

Cellule de DRAM dotée d'un condensateur magnétique

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(43) Date of publication of application:
**22.12.2010 Bulletin 2010/51**

(73) Proprietor: **Northern Lights Semiconductor Corp.
Saint Paul, MN 55113 (US)**

(72) Inventor: **Lai, James Chyi
Saint Paul, MN 55113 (US)**

(74) Representative: **Lang, Christian et al
LangPatent
Anwaltskanzlei
Rosenheimer Strasse 139
81671 München (DE)**

(56) References cited:
**GB-A- 2 453 400    US-A1- 2007 247 784**

**Description**

**BACKGROUND**

**Field of Invention**

The present invention relates to a DRAM cell. More particularly, the present invention relates to a DRAM cell with a magnetic capacitor in the metal layer. We name this device as "McRAM" (Magnetic Capcitor Random Access Memory).

**Description of Related Art**

A Dynamic Random Access Memory (DRAM) cell including a transistor and a storage capacitor per bit has become the most important storage element in electronic system, especially in computer and communication system. The output voltage of a DRAM cell is proportional to the capacitance value of the storage capacitor of the DRAM cell and, therefore, the storage capacitor must have a satisfactory capacitance value to have stable operation of the cell as the applied voltage is scaled.

Furthermore, in a conventional DRAM cell structure, the capacitor is created in the crystal silicon layer because of the need for higher valued capacitance than is typically obtained in the other layers. Also, the capacitor is typically placed adjacent to the transistor and consumes a relatively large and valuable area on the wafer to obtain the needed capacitance values. This makes a DRAM cell large and affects the size of each bit.

However, the main determinant of a DRAM's cost is the density of the memory cells. The goal is to have small-sized memory cells, which means that more of them can be produced at once from a single silicon wafer. This can improve yield, thus reduces the cost.

There are several types of DRAM memory cells that are already available to increase the density, and these memory cells can be divided according to the structure of the capacitor for storing electric charge for information. For example, a trench-type capacitor is formed by forming a deep trench in a semiconductor substrate without increasing the surface area of the semiconductor substrate. The trench-type capacitor can reduce the size of a DRAM cell, but the manufacturing process is difficult and complicated.

Besides, even though these already available memory cells have high density, it comes with the cost of having to refresh the memory periodically. Additional circuitry is required to read and re-write each bit in the memory. This makes the DRAM circuit more complicated, and this means that the memory was not always available for system use because it may be in a refresh cycle. Furthermore, the additional circuitry detracts from the density. DRAM memories are not scaling to remain competitive because of the high area taken by the capacitors used to store the value of the bit.

US 2007/0247784 A1 relates to a magnetic capacitor used in a DRAM cell. The magnetic capacitor includes a dielectric which is disposed between electrodes comprising a magnetic material having a magnetic moment, wherein the magnetic moment of the opposed electrodes are anti-parallel to each other.

GB 2 453 490 A relates to a DRAM cell with a magnetic capacitor including a substrate, a transistor and a magnetic capacitor, the capacitor being formed of two magnetic layers, between which a dielectric layer is sandwiched.

Starting from the latter state of the art it is the object of the present application to provide a new DRAM cell, so that the density of a DRAM may be increased, the manufacturing process is simplified, and the refresh rate is reduced. Thus the cost of manufacturing is reduced.

**SUMMARY**

The above-mentioned object is solved by the DRAM cell according to claim 1. Advantageous improvements of the present invention are the subject matter of dependent claims.

The present invention is directed to a DRAM cell that satisfies this need of increasing the density of the memory device, simplifying the manufacturing process, and reducing the refresh rate.

The DRAM cell includes a substrate, a transistor, and a magnetic capacitor. The substrate is composed of semiconductor material with a main surface, the transistor is formed at the main surface, and the magnetic capacitor is formed in a metal layer. The magnetic capacitor includes a first magnetic layer, a dielectric layer formed on the surface of the first magnetic layer, and a second magnetic layer formed on the surface of the dielectric layer.

The dielectric layer is a non-conductive material and the first magnetic layer and the second magnetic layer are formed by an alloy of CoNiFe.

## BRIEF DESCRIPTION OF THE DRAWINGS

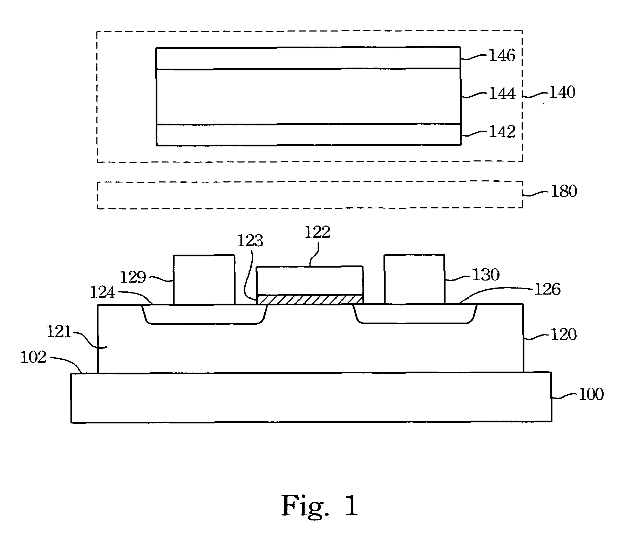

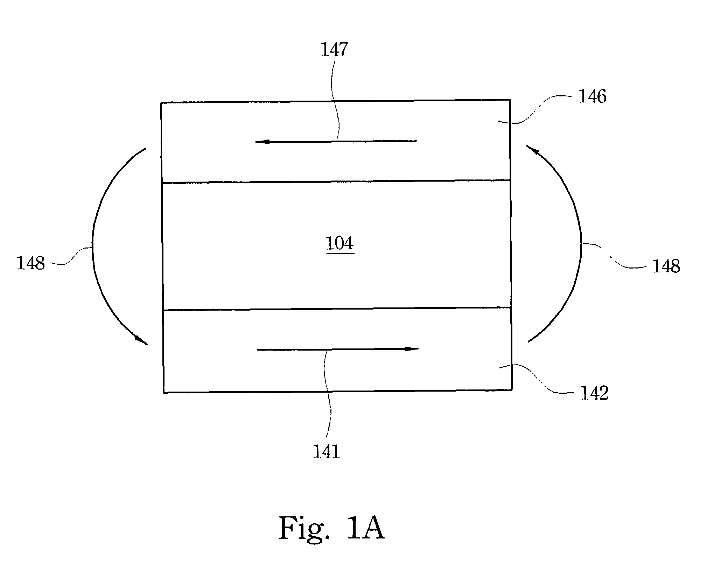

The accompanying drawings are included to provide a further understanding of the invention, and are incorporated in and constitute a part of this specification. The drawings illustrate an embodiment of the invention and, together with the description, serve to explain the principles of the invention. In the drawings, Fig. 1 is a side cross-sectional view of the DRAM cell according to a preferred embodiment of this present invention.

Figure 1A is a schematic diagram to depict the magnetic field to prevent escaping charges from the dielectric layer.

Fig. 2 is a side cross-sectional view of the DRAM cell according to an example not forming part of the claimed invention.

## DESCRIPTION OF THE PREFERRED EMBODIMENTS

Reference will now be made in detail to the present preferred embodiment of the invention, an example of which is illustrated in the accompanying drawings. Wherever possible, the same reference numbers are used in the drawings and the description to refer to the same or like parts.

Please refer to Fig. 1. Fig. 1 is a cross-sectional view of the DRAM cell according to an embodiment of the present invention. A DRAM cell includes a substrate 100, a transistor 120, and a magnetic capacitor 140. We name this device as "McRAM" (Magnetic Capcitor Random Access Memory. However, in the following paragraph, we still use DRAM to describe this invention. The substrate 100 is composed of semiconductor material with a main surface 102. The transistor 120 includes a source region 124 and a drain region 126 formed at the main surface 102 of the substrate 100. The transistor 120 also includes a control gate 122 placed between the source region 124 and the drain region 126, and separated from the substrate 100 by a thin control dielectric 123. The control gate 122 is polysilicon, and the thin control dielectric 123 may be silicon dioxide.

The capacitor 140 is a magnetic capacitor. The capacitor includes a first magnetic layer 142, a dielectric layer 144 formed on the surface of the first magnetic layer 142, and a second magnetic layer 146 formed on the surface of the dielectric layer 144. The material for forming the dielectric layer 144 is a non-conductive material. In an embodiment, the material for forming the dielectric layer 144 is $SiO_2$. The material for forming the first magnetic layer 142 and the second magnetic layer 146 is a magnetic material viz. an alloy of CoNiFe. The distance between the first magnetic layer 142 and the second magnetic layer 146 is larger than 100 Angstrom. Capacitors are generally governed by this equation (1):

$$C = \frac{\varepsilon_o \varepsilon_k A}{r} \quad (1)$$

where C is the capacitance of the capacitor 140, $\varepsilon_0$ is a constant (approximately 8.85e-12), $\varepsilon_k$ is the dielectric constant of the material between the first magnetic layer 142 and the second magnetic layer 146, A is the surface area of the first magnetic layer 142 and the second magnetic layer 146, and r is the distance between the first magnetic layer 142 and the second magnetic layer 146. From the equation (1), if the dielectric constant $\varepsilon_k$ of the material between the first magnetic layer 142 and the second magnetic layer 146 increases, the capacitance will increase.

A GMC (Giant Magnetic Capacitance) effect is used to increase the dielectric constant $\varepsilon_k$. GMC acts, figuratively, like a charge trap that brings electrons to closer, thus increasing electron densities between the first magnetic layer 142 and the second magnetic layer 146.

The magnetic field is provided by the first magnetic layer 142 and the second magnetic layer 146. The magnetic field acts as a force to prevent escaping charges from the dielectric layer 144.

Figure 1A is a schematic diagram to depict the magnetic field to prevent escaping charges from the dielectric layer. Since the direction of dipole 141 of the first magnetic layer 142 is opposite to that of the dipole 147 of the second magnetic layer 146, the first magnetic layer 142 and the second magnetic layer 146 generate a magnetic field 148 to prevent escaping charges from the dielectric layer 144. Therefore, the magnetic field 148 provides additional force to increase electron densities between the first magnetic layer 142 and the second magnetic layer 146. Moreover, capacitor leakage and self-discharge are essentially eliminated as electrons are "trapped" in the magnetic field 148.

Thus, with the strong magnetic field, the capacitance is therefore governed by a modified equation:

$$C = \frac{\varepsilon_o \varepsilon_k' A}{r} \quad (1)$$

where C is the capacitance of the capacitor 140,

$\varepsilon_0$ is a constant (approximately 8.85e-12),

$\varepsilon_k' = \varepsilon_k \times f$, where $f$ is a modified factor, the GMC effect factor ($\sim 10^6$-$10^{12}$), due to the magnetic field 148,

A is the surface area of the first magnetic layer 142 and the second magnetic layer 146,

r is the distance between the first magnetic layer 142 and the second magnetic layer 146.

In other words, when the magnetic field 148 is increased, the capacitance is therefore increased. Each of the first magnetic layer 142 and the second magnetic layer 146 is made from multiple thin film deposited layers each 1 nm thick. Therefore, the magnetic field 148 is increased by increasing the thin film deposited layers forming the first magnetic layer 142 and the second magnetic layer 146. That is that the magnetic field 148 is increased by forming additional thin film deposited layer over the original first magnetic layer 142 and the second magnetic layer 146

It is noted that the symbols '→' are arranged to represent the dipoles of the magnetic sections.

The following table compares the capacitance of a magnetic capacitor with that of a conventional capacitor.

|  | Magnetic capacitor #1 | Magnetic capacitor #2 |
|---|---|---|
| Mcap capacitance measured (Average) | 1.2 nF (at 1kHz) | 96 uF (at 1kHz) |
| **GMC factor (*f*) (Average)** | **$2.0 \times 10^{6}$** | **$1.6 \times 10^{11}$** |
| Conventional capacitance* (i.e. no GMC effect) | 0.6 fF (at *k*=3.4) | 0.6 fF (at *k*=3.4) |

$$*\text{Conventional Capacitance} = \frac{8.85 \times 10^{-12} \times 3.4 \times 1.6 \times 10^{-6} \times 0.55 \times 10^{-6}}{50 \times 10^{-9}} \quad \begin{array}{l} = 5.9 \times 10^{-16} \text{ F} \\ = 0.6 \text{ fF} \end{array}$$

Because of the *f* factor, GMC effect factor ($\sim10^6$-$10^{12}$), from the magnetic field generated by the first magnetic layer 142 and the second magnetic layer 146, the capacitance of the magnetic capacitor is significantly higher the conventional capacitor.

Notice that the capacitor 140 is formed in the metal layer above the transistor 120. Conventional capacitors are created in the crystal silicon layer to obtain higher valued capacitance; however, modern capacitors are capable of obtaining the needed DRAM capacitance values when they are created in the metal layer. As a result, the magnetic capacitor 140 is formed above the transistor 120 in the metal layer 160. However, the magnetic capacitor 140 does not need to be created directly above the transistor 120. When the magnetic capacitor 140 is moved from the crystal silicon layer to the metal layer 160, the overall area of the DRAM cell can be significantly reduced. Besides, the necessary wiring connections for the DRAM cell can be placed in a routing area 180, located in between the transistor 120 and the magnetic capacitor 140, to achieve greater intensity.

With the magnetic capacitor 140 formed in the metal layer of semiconductors, it is now possible to reduce or eliminate the DRAM refresh rate. The magnetic capacitor 140 can store the information just like a standard capacitor, but has low to no leakage and high valued capacitance. Because of low to no leakage, the refresh rate is reduced to allow more time for system operation. The leakage may be so low as to eliminate the refresh altogether. This allows the removal of the refresh circuitry. Additionally, with no refresh, this memory maintains its values even after the power is removed. As a result, this invention turns DRAM into non-volatile memory, and can be used to replace Flash memories. Besides, the magnetic capacitor 140 is radiation hard in environments with high levels of radiation. This is because the energy needed to upset the magnetic capacitor 140 must be much higher than most radiation specifications to upset a bit. However, the capacitance the magnetic capacitor 140 stored to maintain memory is high enough to withstand significant radiation from environments, thus the magnetic capacitor 140 is radiation hard.

Furthermore, the capacitance values of modern capacitors have increased dramatically, with dielectric constants over 3000, thinner dielectrics, and surface roughness. This allows that the magnetic capacitor 140 can take up less space than the transistor 120. Note that even though the gate length of the transistor 120 is very small, the magnetic capacitor 140 has the area for the entire transistor 120, including contacts 129 and 130, the control gate 122 and a diffusion area 121.

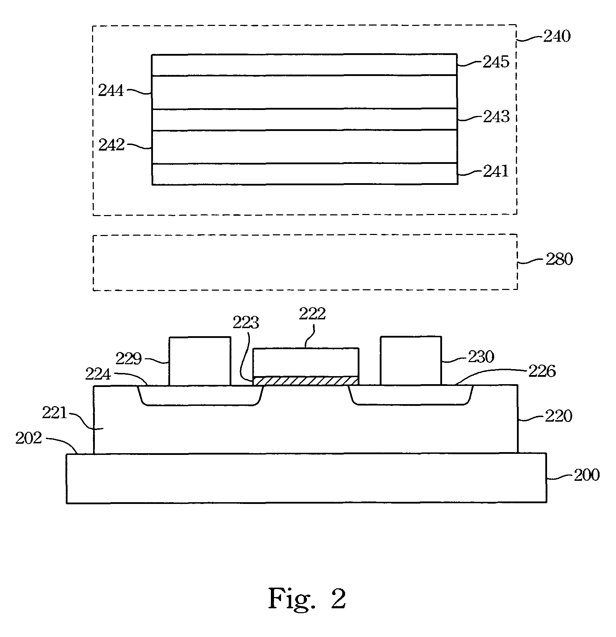

Please refer to Fig. 2, a cross-sectional view of the DRAM cell according to an example not forming part of the claimed invention. A DRAM cell includes a substrate 200, a transistor 220, and a magnetic capacitor 240. The substrate 200 is composed of semiconductor material with a main surface 202. The transistor 220 includes a source region 224 and a drain region 226 formed at the main surface 202 of the substrate 200. The transistor 220 also includes a control gate 222 placed between the source region 224 and the drain region 226, and separated from the substrate 200 by a thin control dielectric 223. The control gate 222 is polysilicon, and the thin control dielectric 223 may be silicon dioxide.

Modern capacitors are capable of obtaining the needed DRAM capacitance values when they are created in the metal layer. As a result, the magnetic capacitor 240 can be formed above the transistor 220. However, the magnetic capacitor 240 does not need to be created directly above the transistor 220. When the magnetic capacitor 240 is created in the metal layer, the overall area of the DRAM cell can be significantly reduced.

Notice that the capacitor 240 is built in multiple layers with the first magnetic layer 241, the third magnetic layer 243, and the fifth magnetic layer 245. When the capacitor does not provide sufficient capacitance with a single layer of capacitance, multiple layers can be placed to provide the desired capacitance. In addition, this allows for scaling to smaller dimensions because the capacitor size relative to the transistor size remains about the same. As the size of the transistor gets smaller, the amount of current it can handle also gets smaller. That is when the DRAM cell requires larger amount of capacitance relative to the size of the transistor. The capacitor can be built with multiple layers to provide the additional capacitance. So the first magnetic layer 241, the third magnetic layer 243, and the fifth magnetic layer 245 are placed to provide the desired capacitance for the transistor 220.

Besides, the necessary wiring connections for the DRAM cell can be placed in a routing area 280, located in between the transistor 220 and the magnetic capacitor 240, to achieve greater intensity. Lastly, the capacitance values of modern capacitors have increased dramatically, with dielectric constants over 3000, thinner dielectrics, and surface roughness. This allows that the magnetic capacitor 240 takes up less space than the transistor 220. Note that even though the gate length of the transistor 220 is very small, the magnetic capacitor 240 has the area for the entire transistor 220, including contacts 229 and 230, the control gate 222 and a diffusion area 221.

The difference between the figure 1 embodiment and the figure 2 example is that the capacitor in figure 2 is built with multiple layers to provide the desired capacitance when the invention scales to small dimensions or one single layer does not provide sufficient capacitance.

Moreover, since the magnetic capacitor still can retain the electric charge when the power supplied to the magnetic capacitor is off, the DRAM become as Non-Volatile memory likes NAND and NOR flash when the magnetic capacitor into DRAM structure.

From the description above, we can conclude that this invention of a small-sized DRAM cell satisfies the need of increasing the density of the DRAM cells, thus lowers the cost of fabrication. The small-sized DRAM cell is achieved by creating the magnetic capacitor in the metal layer, and has the capability of increasing the speed of DRAM integrated circuits and reducing the power consumed by DRAM integrated circuits. Because of the improved speed, this memory cell can be used to replace SRAM. Furthermore, the magnetic capacitor has low to no leakage, so DRAM refresh rate can be reduced or eliminated. When DRAM refresh rate is eliminated, the refresh circuitry can be removed, and the DRAM cell becomes non-volatile. Therefore, this invention can replace other standard electronic forms of memory. Besides, the magnetic capacitor is radiation hard in environments with high levels of radiation.

It will be apparent to those skilled in the art that various modifications and variations can be made to the structure of the present invention whithin the scope of the claims.

**Claims**

1. A DRAM cell, comprising:

   a substrate (100) having semiconductor material with a main surface (102);
   a transistor (120) formed at the main surface (102); and
   a magnetic capacitor (140) formed in a metal layer located above the transistor (120), wherein the magnetic capacitor (140) includes:

      a first magnetic layer (142);
      a dielectric layer (144) formed on the surface of the first magnetic layer (142); and
      a second magnetic layer (146) formed on the surface of the dielectric layer (144), wherein a direction of the dipole (141) of the first magnetic layer (142) is opposite to that of the dipole (147) of the second magnetic layer (146) to generate a magnetic field to prevent escaping charges from the dielectric layer (144),
      wherein the first magnetic layer (142) and the second magnetic layer (146) are formed by an alloy of CoNiFe, **characterised in that** the distance between the first magnetic layer and the second magnetic layer is larger than 10 nanometers,
      wherein the first magnetic layer (142) is made from multiple thin film deposited layers and each thin film deposited layer is 1 nm thick, and
      wherein the second magnetic layer (146) is made from multiple thin film deposited layers and each thin film deposited layer is 1 nm thick.

2. The DRAM cell of claim 1, wherein the transistor (120) includes:

   a source region (124);
   a drain region (126); and
   a control gate (122) placed between the source region (124) and the drain region (126) and separated from the substrate (100) by a thin control dielectric (123).

3. The DRAM cell of claim 1, wherein the first magnetic layer (142) and the second magnetic layer (146) generate a Giant Magnetic Capacitance effect.

4. The DRAM cell of claim 1, further comprising a routing area (180) between the transistor (120) and the magnetic capacitor (140) for the wiring connections of the DRAM cell.

**Patentansprüche**

1. DRAM - Zelle, die umfasst:

   ein Substrat (100), das ein Halbleitermaterial mit einer Hauptoberfläche (102) aufweist;
   einen Transistor (120), der an der Hauptoberfläche (102) ausgebildet ist; und
   einen magnetischen Kondensator (140), der in einer Metallschicht ausgebildet ist, die oberhalb von dem Transistor (120) angeordnet ist, wobei der magnetische Kondensator (140) umfasst:

      eine erste magnetische Schicht (142);
      eine dielektrische Schicht (144), die an der Oberfläche der ersten magnetische Schicht (142) ausgebildet ist; und

eine zweite magnetische Schicht (146), die an der Oberfläche der dielektrischen Schicht (144) ausgebildet ist, wobei eine Richtung des Dipols (141) der ersten magnetische Schicht (142) entgegengesetzt zu der des Dipols (147) der zweiten magnetischen Schicht (146) ist, um ein magnetisches Feld zu erzeugen, um den Verlust von Ladungen aus der dielektrischen Schicht (144) zu verhindern,

wobei die erste magnetische Schicht (142) und die zweite magnetische Schicht (146) durch eine Legierung aus CoNiFe ausgebildet sind,

**dadurch gekennzeichnet, dass**

der Abstand zwischen der ersten magnetische Schicht und der zweiten magnetischen Schicht größer als 10 nm ist,

wobei die erste magnetische Schicht (142) aus einer Vielzahl dünner Filmabscheidungsschichten hergestellt ist und wobei jede der dünnen Filmabscheidungsschichten 1 nm dick ist, und

wobei die zweite magnetische Schicht (146) aus einer Vielzahl von dünnen Filmabscheidungsschichten hergestellt ist und wobei jede der dünnen Filmabscheidungsschicht 1 nm dick ist.

2. DRAM - Zelle nach Anspruch 1, wobei der Transistor (120) umfasst:

einen Sourcebereich (124);

einen Drainbereich (126); und

ein Steuergate (123), das zwischen dem Sourcebereich (124) und dem Drainbereich (126) platziert ist und von dem Substrat (100) durch ein dünnes Steuerdielektrikum (123) getrennt ist.

3. DRAM - Zelle nach Anspruch 1, wobei die erste magnetische Schicht (143) und die zweite magnetische Schicht (146) einen Riesenmagnetokapazitäts - Effekt erzeugen.

4. DRAM - Zelle nach Anspruch 1, die ferner zwischen dem Transistor (120) und dem magnetischen Kondensator (140) einen Leitbereich (180) für die Drahtverbindungen der DRAM - Zelle umfasst.

**Revendications**

1. Cellule DRAM comprenant:

un substrat (100) ayant un matériau semiconducteur avec une surface principale (102) ;

un transistor (120) formé sur la surface principale (102) et

un condensateur magnétique (140) formé dans une couche métallique située au-dessus du transistor (120), le condensateur magnétique (140) comprenant :

une première couche magnétique (142),

une couche diélectrique (144) formée sur la surface de la première couche magnétique (142) et

une seconde couche magnétique (146) formée sur la surface de la couche diélectrique (144), une direction du dipôle (141) de la première couche magnétique (142) étant opposée à celle du dipôle (147) de la seconde couche magnétique (146) pour générer un champ magnétique pour empêcher des fuites de charges de la couche diélectrique (144),

la première couche magnétique (142) et la seconde couche magnétique (146) étant formées par un alliage de CoNiFe,

**caractérisée en ce que** la distance entre la première couche magnétique et la seconde couche magnétique est supérieure à 10 nanométres,

la première couche magnétique (142) étant constituée par des couches déposées minces multiples et chaque couche mince déposée ayant une épaisseur d'1 nm et

la seconde couche magnétique (146) étant constituée par des couches déposées minces multiples et chaque couche mince déposée ayant une épaisseur d'1 nm.

2. Cellule DRAM selon la revendication 1 dans laquelle le transistor (120) comprend :

une région de source (124),

une région de drain (126) et

une grille de commande (122) placée entre la région de source (124) et la région de drain (126) et séparée du substrat (100) par un diélectrique de commande à couche mince (123).

3. Cellule DRAM selon la revendication 1 dans laquelle la première couche magnétique (142) et la seconde couche magnétique (146) génèrent un effet de capacité magnétique géante.

4. Cellule DRAM selon la revendication 1 comprenant de plus une zone de routage (180) entre le transistor (120) et le condensateur magnétique (140) pour les raccords de câblage de la cellule DRAM.

Fig. 1

Fig. 1A

Fig. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070247784 A1

- GB 2453490 A